Europäisches Patentamt

European Patent Office

Office européen des brevets

(19)

(11) **EP 1 496 612 A2**

(12) **EUROPEAN PATENT APPLICATION**

(43) Date of publication:
**12.01.2005 Bulletin 2005/02**

(51) Int Cl.⁷: **H03F 1/32**

(21) Application number: **04016001.2**

(22) Date of filing: **07.07.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **09.07.2003 JP 2003272181**

(71) Applicant: **NEC CORPORATION**
**Tokyo (JP)**

(72) Inventors:
• **Iwasaki, Motoya**
  **Tokyo (JP)**
• **Doi, Yoshiaki**
  **Tokyo (JP)**

(74) Representative: **Betten & Resch**
**Patentanwälte,**
**Theatinerstrasse 8**
**80333 München (DE)**

(54) **Non-linear compensation circuit, transmission apparatus and non-linear compensation method**

(57)    An apparatus includes an amplitude converter (102), receiving a complex baseband signal to output an amplitude thereof, a memory (103), receiving an amplitude from the amplitude converter as an address to output an inverse gain associated with the amplitude, a reciprocal converter (104) receiving an output of the memory as input and outputting a reciprocal of the memory output, a FIR filter (105) for filtering an output signal of the reciprocal converter, a reciprocal converter (106) receiving an output of the FIR filter as input to output a reciprocal of the output of the FIR filter, and a complex multiplier (107) for executing complex multiplication of the complex baseband signal and an output of the reciprocal converter (106).

FIG . 1

EP 1 496 612 A2

## Description

FIELD OF THE INVENTION

This invention relates to a circuit and a method for non-linear compensation of an amplifier used in e.g. the mobile communication. More particularly, it relates to a compensation circuit and a compensation method in case the amplifier has a characteristic termed a memory effect.

BACKGROUND OF THE INVENTION

In digital mobile communication of these days, the CDMA (Code Division Multiple Access) communication system is widely used to enhance the ability to withstand interference. With the CDMA communication system, in which the instantaneous power is increased as compared to the average power, it is retained to be necessary to maintain the linearity of the high output power amplifier of a transmitter to an extremely high output level in order to reduce cross-talk power between neighboring channels. The result is that the amplifier is increased in size and cost, while the power consumption is increased.

Thus, the technique of pre-distortion, in which an inverse characteristic of the non-linearity in the baseband unit is applied to use a non-linear amplifier, is now being searched briskly.

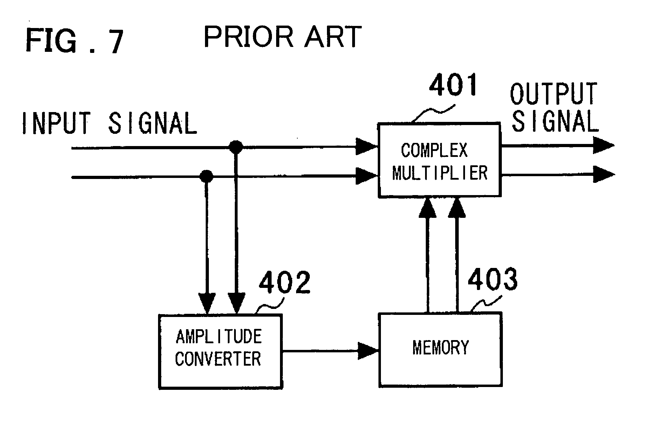

Fig.7 is a diagram illustrating the configuration of a conventional pre-distorter. In Fig.7, two signal lines, drawn parallel to each other, represent a complex signal, in-phase and quadrature components of which are a real part and an imaginary part, respectively. An amplitude converter 402, which receives an input signal (complex baseband signal), outputs an amplitude of the input signal (an absolute value of the complex signal). An output of the amplitude converter 402 is supplied as an address to a memory 403 forming a lookup table. In the memory 403, there are stored data representing the inverse of a gain characteristic (the inverse characteristic of an input/output characteristic) of an amplifier, not shown, by a complex number, with respect to the input amplitude, so that inverse gain characteristic data associated with the amplitude information applied as an address input (compensation data) is output. A complex multiplier 401 performs complex multiplication of the inverse gain characteristic data, output from the memory 403, with the input complex baseband signal, to output the result of multiplication. The complex multiplier 401 outputs a signal corresponding to the input signal added by the non-linear inverse characteristic.

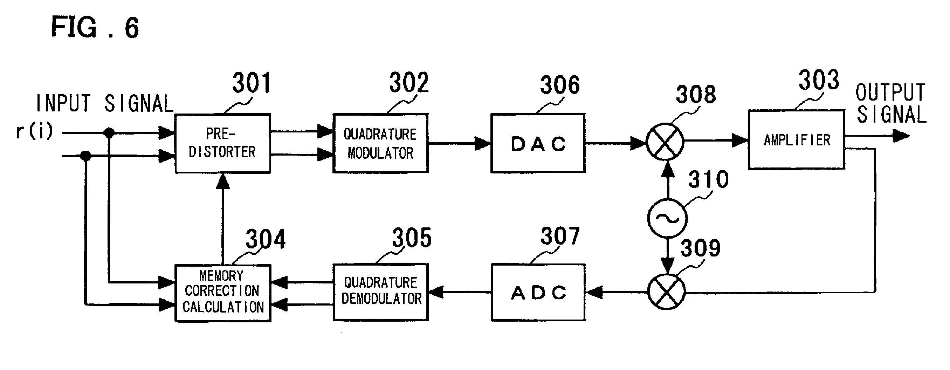

Fig.6 shows the structure of a transmitter having a pre-distorter configured as shown in Fig.7. Referring to Fig.6, a complex baseband signal (a complex signal indicated by two lines for in-phase and quadrature components) is added to with an inverse gain characteristic data (inverse characteristic of the input/output characteristic of the amplifier) by the pre-distorter 301. The complex baseband signal output from the pre-distorter 301 is quadrature-modulated by a quadrature modulator 302 and the modulated signal output from the quadrature modulator 302 is converted to analog signal by a digital-to-analog converter (DAC) 306. The analog signal is mixed by a frequency mixer 308 with a locally oscillated signal from a local oscillator 310 (up-conversion) and amplified in power by an amplifier 303. An output signal from the amplifier 303 is mixed by a frequency mixer 309 with the locally oscillated signal from the local oscillator 310 (downconversion) and converted into a digital signal by an analog-to-digital converter (ADC) 307 so as to be supplied to a quadrature demodulator 305. The quadrature demodulator 305 quadrature-demodulates an output signal of the amplifier 303. The demodulated signal (complex signal indicated by two lines for in-phase and quadrature components), output from the quadrature demodulator 305, is supplied to a memory correction calculating unit 304. The memory correction calculating unit 304 compares the complex input signal, supplied to the pre-distorter 301, with the complex signal, quadrature-demodulated by the quadrature demodulator 305, to estimate the gain of the amplifier 303, and sets the inverse characteristic of the gain of the amplifier 303 as data for the memory (403 of Fig.7) in the pre-distorter 301.

As the pre-distorter for the amplifier, reference is made to the following Patent Documents 1 to 3. The Patent Document 1 discloses a pre-distorter for pre-modifies an input signal to the amplifier by the inverse characteristic of the input/output characteristic of the amplifier, in order to reduce the cross talk power in neighboring channels of amplifier outputs, in which a correction coefficient for the differential and/or the integration of the input signal is determined, and in which the input signal is modified based on the so determined correction coefficient to output the so modified signal as a final pre-distortion signal. The Patent Document 2 shows the structure of a non-linear compensation circuit of the adaptive pre-distortion system, which assures high-speed high-precision compensation despite the reduced circuit size. In addition, the Patent Document 3 discloses a method for generating compensation data (the inverse of the input/output characteristics of power amplifying means taking into account the non-linear components of power amplifying means) for compensating the non-linear distortion in the power amplifying means.

SUMMARY OF THE INVENTION

Meanwhile, in connection with the non-linear characteristic of the amplifier 303, there are cases where the amplifier, in particular the high-power amplifier (HPA) exhibits a characteristic termed a memory effect or memory distortion. This is a case where the non-linear distortion of the amplifier 303 exhibits frequency dependency against the modulation frequency of the input signal or discrete harmonic frequencies of plural waves in multi-carrier amplification.

With the conventional circuit structure, explained with reference to Figs.6 and 7, such high frequency dependency may give rise to a problem that the effect of compensation by the pre-distorter 301 is diminished, such that the distortion of the amplifier 303 cannot be compensated sufficiently.

Accordingly, it is an object of the present invention to provide an apparatus and a method whereby, in compensating the non-linear characteristic of the amplifier, in a baseband unit, it is possible to reduce distortion ascribable to the memory effect of the amplifier.

The circuit in accordance with one aspect of the present invention, which provides an inverse characteristic of an input/output characteristic, termed 'a gain characteristic', of an amplifier, to an input signal supplied to the amplifier, to compensate the non-linear characteristic of the amplifier, includes first means for deriving an inverse gain as an inverse characteristic of the gain of the amplifier with respect to the input signal, and for outputting a reciprocal of the inverse gain, a filter supplied with the reciprocal for filtering the reciprocal to output a filtered output, second means for finding a reciprocal of the filtered output to output the reciprocal of the filtered output, and a multiplier for multiplying the input signal and an output of the second means.

A circuit in accordance with another aspect of the present invention includes first means for deriving a gain of an amplifier with respect to an input signal to output the resulting gain, a filter supplied with the gain for filtering the gain to output a filtered output, second means for finding a reciprocal of the filtered output to output the reciprocal of the filtered output, and a multiplier for multiplying the input signal with an output of the second means.

A method in accordance with another aspect of the present invention includes:

> a step of deriving an inverse characteristic of a gain of an amplifier with respect to an input signal, and for outputting a reciprocal of the inverse characteristic;
> a step of filtering the reciprocal, a step of finding a reciprocal of the filtered output; and
> a step of multiplying the input signal with the reciprocal of the filter output.

A method in accordance with still another aspect of the present invention includes:

> a step of deriving a gain of an amplifier with respect to an input signal;
> a step of filtering the gain to output a filtered output;
> a step of finding a reciprocal of the filtered output; and
> a step of multiplying the input signal with the filtered output.

According to the present invention, it is possible to compensate the distortion ascribable to the memory effect of the amplifier.

BRIEF DESCRIPTION OF THE DRAWINGS

> Fig.1 shows the structure of a pre-distorter of a first embodiment of the present invention.
> Fig.2 illustrates the memory effect of an amplifier embodying the present invention.
> Fig.3 shows the processing sequence of the first embodiment of the present invention.
> Fig.4 shows the structure of a pre-distorter of a second embodiment of the present invention.
> Fig.5 shows the processing sequence of the second embodiment of the present invention.
> Fig.6 shows the structure of a transmitter having a pre-distorter.
> Fig.7 shows the structure of a conventional pre-distorter.

PREFERRED EMBODIMENTS OF THE INVENTION

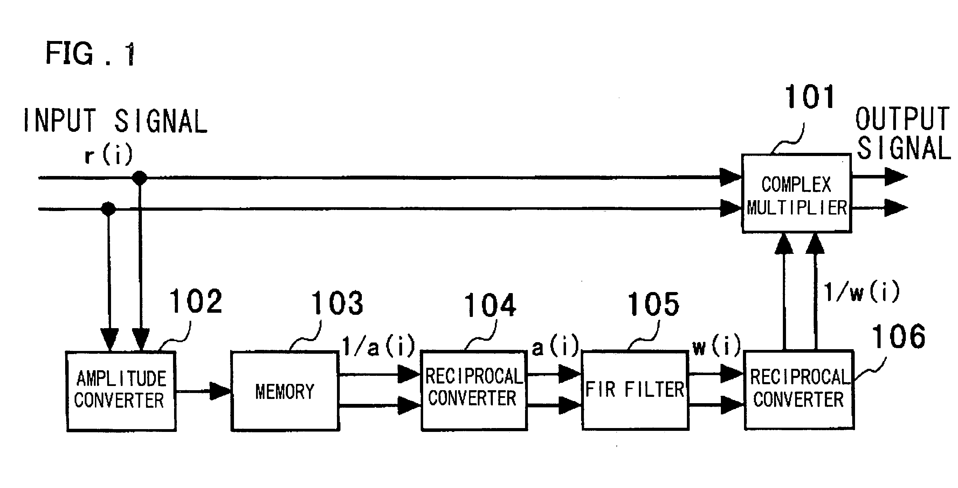

The preferred embodiment for carrying out the present invention is now described. Referring to Fig.1, a pre-distorter according to an embodiment of the present invention, includes an amplitude converter 102, which receives a complex baseband signal and outputs an amplitude of the complex baseband signal, and a memory 103, which holds data corresponding to complex number expression of the inverse of input-to-output characteristic of an amplifier, termed an inverse gain characteristic, with respect to the input amplitude, which is supplied with an amplitude from an amplitude converter 102, as an address, and which outputs an inverse gain corresponding to the amplitude. The pre-distorter also includes a first reciprocal converter 104 supplied with an output of the memory 103 to output its reciprocal, and a FIR (finite impulse response) type digital filter 105, which receives and filters an output signal of the first reciprocal converter 104. The pre-distorter further includes a second reciprocal converter 106, which receives an output of the filter 105 to output its reciprocal, and a complex multiplier 101 for carrying out complex multiplication of the complex baseband signal and the output of the second reciprocal converter 106.

In the conventional adaptive pre-distorter, explained with reference to Fig.7, an inverse characteristic of the amplifier gain, corresponding to the amplitude of the input signal (absolute value of the complex number) is multiplied by the input signal to execute pre-distortion.

According to the present invention, a reciprocal of the inverse characteristic of the gain of an amplifier (303 of Fig.6) is supplied to a filter 105 having a filtering characteristic corresponding to the memory effect of the amplifier and again a reciprocal of the filter output is taken and multiplied with the input signal. Alternatively, according to the present invention, the amplifier gain, corresponding to the input signal (obtained from the input/output characteristic of the amplifier), is supplied a filter 105 having a filter characteristic corresponding to the memory effect of the amplifier and again a reciprocal of the filter output is taken and multiplied with the input signal. Further description is now made in detail with reference to a more concrete embodiment.

[Embodiment 1]

A pre-distorter according to a first embodiment, shown in Fig.1 is built as the pre-distorter 301 in a transmitter shown in Fig.6.

Referring to Fig.1, the pre-distorter according to the first embodiment, includes an amplitude converter 102, which receives a complex baseband signal $r(i)$ and outputs its amplitude, and a memory 103, storing and holding an inverse characteristic of the input/output characteristic of an amplifier to form a lookup table for outputting the inverse characteristic associated with an input address. The pre-distorter also includes a first reciprocal converter 104 which receives an output of the memory 103 and calculates and outputs a reciprocal thereof, and a FIR (finite impulse response) type digital filter 105, which receives an output signal of the first reciprocal converter 104 and performs filter calculation to output a resulting signal. The pre-distorter further includes a second reciprocal converter 106, which receives an output of the FIR filter 105 as an input and outputs its reciprocal, and a complex multiplier 101 which carries out complex multiplication of a complex baseband signal $r(i)$ and the reciprocal output from the second reciprocal converter 106.

The complex baseband signal $r(i)(=r_I(i)+jr_Q(i)$, where $r_I(i)$ is an in-phase component, $r_Q(i)$ is a quadrature component and $j^2 =-1$, is converted by the amplitude converter 102 into an amplitude $(= \{r_I(i)^2 +r_Q(i)^2\}^{1/2})$. The amplitude is supplied as an address to the memory 103 for pre-distortion and an inverse characteristic (an inverse gain) associated with the address is output.

The inverse gain (complex signal) $1/a(t)$, output from the memory 103 in keeping with the amplitude from the amplitude converter 102, is converted by the first reciprocal converter 104 into a reciprocal $a(t)$. The reciprocal $a(t)$ of the inverse gain is supplied to the FIR filter 105 from which a signal $w(i)$ is output. An output signal $w(i)$ of the FIR filter 105 is expressed, as convolution of filter coefficients (impulse response) $h(0)$, $h(1)$, $h(2)$, ..., $h(n)$, where N is the number of orders of the filter, and the signal $a(i)$, by the following equation (1):

$$w(i)= \Sigma_{j=0}^{N} h(j) \cdot a(i-j) . \qquad (1)$$

An output signal $w(i)$ $(=w_I(i)+jw_Q(i)$, where $w_I(i)$ is an in-phase component, $jw_Q(i)$ is a quadrature component and $j^2 =-1$), is again converted by the second reciprocal converter 106 into a reciprocal $1/w(i)(= \{w_I(i)-jw_Q(i)\} / \{w_I(i)^2 + w_Q(i)^2\})$ which is supplied to the complex multiplier 101. The complex multiplier 101 executes complex multiplication of the input signal $r(i)$ and $1/w(i)$ to output a resulting signal.

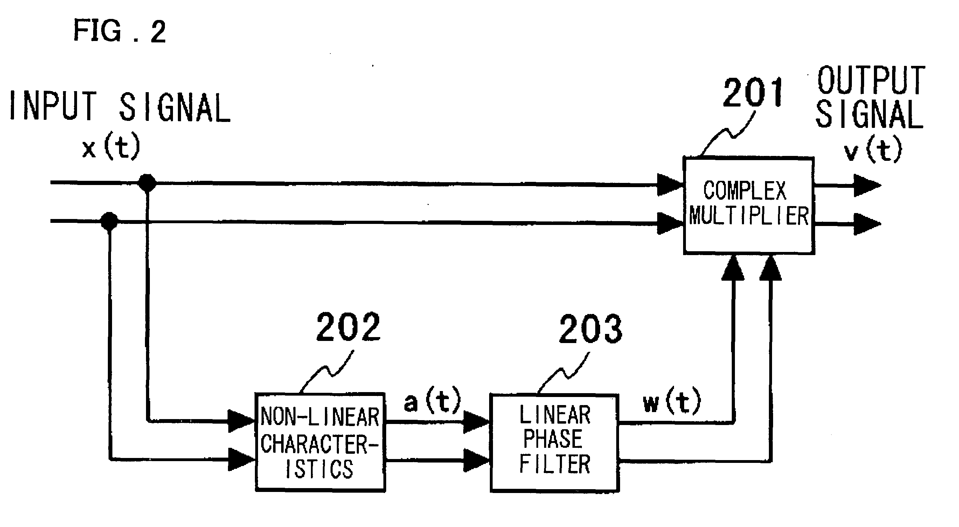

In connection with the FIR filter 105, the memory effect of the amplifier is now explained. Fig.2 shows a modeled operation of the memory effect of an amplifier (see 303 of Fig.6) compensated by the pre-distorter. The amplifier (see 303 of Fig.6) amplifies a quadrature-modulated up-converted analog signal (RF signal). In the model shown in Fig.2, the signal is a complex signal (analog signal) and the model is represented as time-continuous model, for illustrating the compensation effect by the pre-distorter. In the circuit of Fig.1, the respective signals are digital signals, and the model is the time-discrete model.

In an amplifier, devoid of the memory effect, the product of the complex input signal $x(t)$ to the amplifier and the gain $a(t)$ of the amplifier represents an output signal $v(t)$ of the amplifier, as indicated by the following equation (2)

$$v(t)=a(t) \cdot x(t) \qquad (2)$$

On the other hand, in an amplifier having the memory effect, a product with the input signal $x(t)$ of a signal $w(t)$, obtained on filtering the gain $a(t)$ of the amplifier devoid of the memory effect, represents an output $v(t)$ of the amplifier.

The signal $w(t)$, filtered by a filter 203 (linear phase filter) having a characteristic corresponding to the memory effect, is represented by an integration over continuous time of $a(t)$ and $h(\tau)$, over continuous time, as an impulse response of the filter 203 (convolutional integration), as indicated by the equation (3)

$$w(t)= \int h(\tau) \cdot a(t-\tau)d\tau \qquad (3)$$

The output $w(t)$ of this filter 203, multiplied (by complex multiplication) by the input signal $x(t)$, as indicated by the equation(4):

$$v(t)=w(t) \cdot x(t)=x(t) \cdot \{ \int h(\tau) \cdot a(t-\tau)d\tau \} \qquad (4)$$

represents an output $v(t)$ of the amplifier.

Fig.2 depicts a block diagram of the above operation (equation (4)). Referring to Fig.2, a block 202 of a non-linear characteristic outputs a gain $a(t)$ of an amplifier devoid of the memory effect. This gain $a(t)$ is filtered by a filter 203 and supplied to a complex multiplier 201 so as to be multiplied with the input signal $x(t)$.

In the pre-distorter 301, the input signal x(t) supplied to the amplifier needs to be distorted at the outset so that the output v(t) will be equal to the input signal r(t). From the above equation (4), it is sufficient to perform the following processing:

$$x(t)=r(t)/w(t)=r(t)/\{ \int h( \tau )\cdot a(t-\tau )d\tau \} \qquad (5)$$

The processing of the equation (5) may be implemented by the structure shown in Fig.1. However, in the pre-distorter 301, the filtering processing $\int h(\tau) \cdot a(t-\tau)d\tau$ of the equation (5) is the convolution processing over discrete time.

Referring again to Fig.1, the structure of the amplitude converter 102 and the memory 103 is similar to that shown in Fig.7. An output of the memory 103 (complex data) is an inverse characteristic of the amplifier gain, that is, 1/a(i) (inverse gain). The reciprocal of 1/a(i) is a(i), while the output signal of the FIR filter 105 is w(i). The reciprocal of the output w(i) of the FIR filter 105 is multiplied by the input signal r(i), to yield the following equation (6)

$$r(i)/w(i)=r(i)/ ( \Sigma_{j = 0}^{N} h(j)\cdot a(i-j)\} \qquad (6)$$

That is, the signal output from the complex multiplier 101 by the processing shown in Fig.1 is converted, as shown in the equation (6). If supplied to the amplifier having the memory effect shown in Fig.2, the signal is converted, as indicated by the equation (4). Consequently, the relationship between the output and the input of the amplifier may be obtained by substituting the equation (5) into the equation (4). By equating the filter characteristic to that of the memory effect of the amplifier of Fig.2, the output signal is approximately equal to the input signal r(t), as indicated by the equation (7), thereby compensating the distortion due to the amplifier.

$$v(t)=r(t)/\{ \int h( \tau ) \cdot a(t-\tau )d\tau \} \times \{ \int h( \tau ) \cdot a(t-\tau )d\tau \}$$

$$=r(t) \qquad (7)$$

Referring to Fig.1, the amplitude converter 102 may be designed and constructed as a power converter. The power converter converts the complex input signal $r(i)(=r_I(i)+jr_Q (i))$ into its power $(=r_I(i)^2+r_Q(i)^2)$ and the power value is supplied as an address of the memory 103 for pre-distortion. Meanwhile, in Fig.1, control is performed so that the input signal r(i) (complex baseband signal) is delayed by a sum of the delay time by the amplitude converter 102, that by the memory 103, that by the first reciprocal converter 104, that by the digital filter 105 and that by the second reciprocal converter 106, and entered to the complex multiplier 101 and so that the input signal r(i) is multiplied by 1/w(i) corresponding to the input signal r(i). It is of course possible to store e.g. an input signal r(i) (complex baseband signal) transiently in e.g. a register and to take out the stored signal in synchronism with the output timing of 1/w(i) from the second reciprocal converter 106 to adjust the delay.

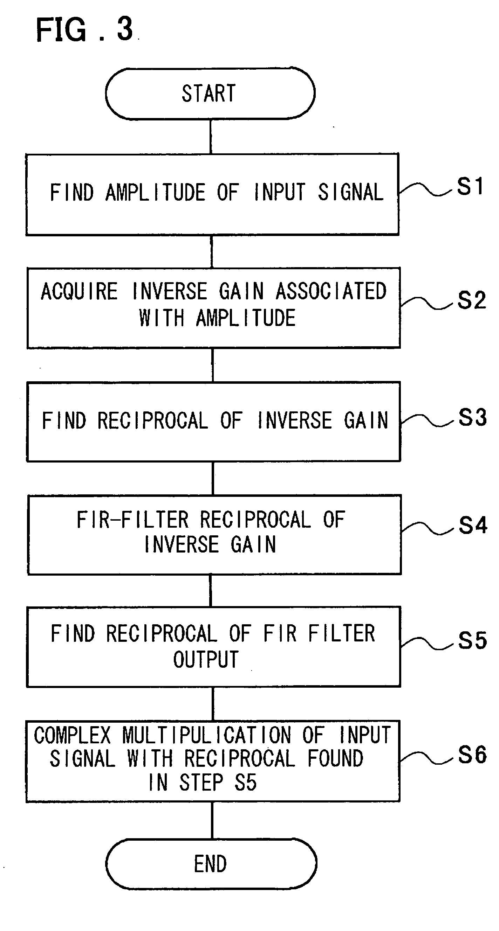

Fig.3 is a flowchart for illustrating the processing sequence in the first embodiment of the present invention shown in Fig.1. Referring to Figs.1 and 3, the method of the first embodiment of the present invention is explained.

The amplitude of the complex baseband signal is obtained by the amplitude converter 102 (step S1).

The inverse gain, corresponding to the amplitude, is then found from the memory 103, having stored therein an inverse characteristic of the input/output characteristic of the amplifier (inverse gain characteristic) (step S2).

The reciprocal of the inverse gain is then obtained by the first reciprocal converter 104 (step S3).

The reciprocal of the inverse gain is obtained by the FIR filter 105 (step S4).

The second reciprocal converter 106, supplied with the filtered reciprocal, finds a reciprocal thereof (step S5).

The complex multiplier 101 performs complex multiplication of the complex baseband signal and the reciprocal found in the step S5 (step S6).

[Embodiment 2]

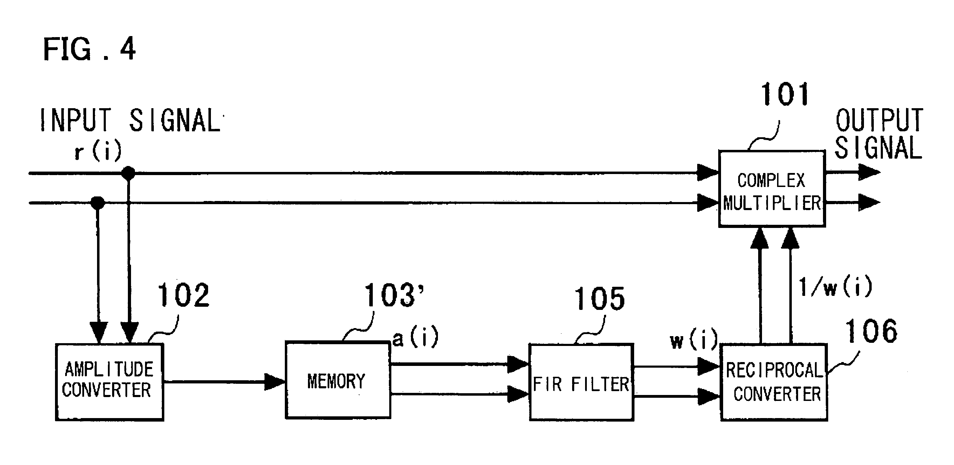

The second embodiment of the present invention is hereinafter explained. Referring to Fig.4 which shows the structure of the second embodiment of the present invention, in the present embodiment, data stored in a memory 103' is the input/output characteristic of the amplifier, and hence is the gain characteristic of the amplifier. In this manner, the first reciprocal converter 104 of Fig.1 may be omitted.

In the present embodiment, the amplitude of the complex baseband signal is found by the amplitude converter 102. The gain a(i), corresponding to the amplitude, is output from the memory 103'. The FIR filter 105 filters the gain a(i). The second reciprocal converter 106 finds the reciprocal of the filtered gain w(t). The complex multiplier 101 multiplies the complex baseband signal with the reciprocal output from the second reciprocal converter 106.

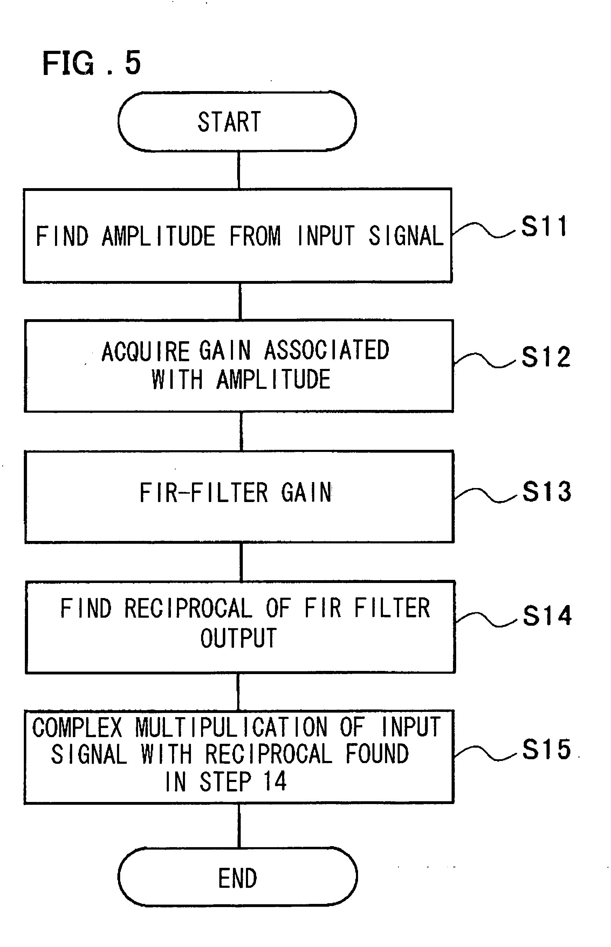

Referring to Figs.4 and 5, the method of the second embodiment of the present invention is explained.

The amplitude of the complex baseband signal is obtained by the amplitude converter 102 (step S11).

The gain of the amplifier, associated with the amplitude, is then obtained from the memory 103', having stored therein the input/output characteristic (gain characteristic) of the amplifier (step S12).

The FIR filter 105 filters the gain from the memory 103' (step S13).

The second reciprocal converter 106, supplied with the filtered reciprocal, finds its reciprocal (step S14).

The complex multiplication of the complex baseband signal and the reciprocal found in the step S 14 is carried out (step S15).

The pre-distorter of each of the above-described embodiments is used as the pre-distorter 301 of Fig.6. Meanwhile, if the pre-distorter of the second embodiment is used, a memory correction calculating unit 304 of Fig.6 corrects data of the input/output characteristic of the amplifier (gain data) based on the input signal and the demodulated signal from a quadrature demodulator 305.

In the above embodiments, the amplitude converter 102, memory 103 (103') and the first reciprocal converter 104 may, of course, be replaced by other calculating circuits performing equivalent processing operations.

The amplitude converter 102 and the memory 103 (103') may, of course, be similarly replaced by other calculating circuits performing equivalent processing operations.

Moreover, in the above embodiments, the filter coefficient h(i) and/or the number of filter orders of the FIR filter may, of course, be varied. Although the present invention has so far been explained with reference to the above-described embodiments, the present invention is not limited to these embodiments and may comprise various modifications or corrections that may readily occur to those skilled in the art within the scope of the invention.

According to the present invention, described above, it is possible to compensate non-linear distortion of the amplifier in case such distortion exhibits frequency dependency against the modulation frequency of the input signal. Thus, the apparatus and the method of the present invention may conveniently be used for e.g. a transmission apparatus of the mobile communication system.

According to an embodiment, an apparatus includes an amplitude converter (102), receiving a complex baseband signal to output an amplitude thereof, a memory (103), receiving an amplitude from the amplitude converter as an address to output an inverse gain associated with the amplitude, a reciprocal converter (104) receiving an output of the memory as input and outputting a reciprocal of the memory output, a FIR filter (105) for filtering an output signal of the reciprocal converter, a reciprocal converter (106) receiving an output of the FIR filter as input to output a reciprocal of the output of the FIR filter, and a complex multiplier (107) for executing complex multiplication of the complex baseband signal and an output of the reciprocal converter (106).

**Claims**

1. A non-linear compensation circuit for providing an inverse characteristic of an input/output characteristic, termed 'a gain characteristic', of an amplifier, as to an input signal supplied to said amplifier, and for compensating a non-linear characteristic of said amplifier, **characterized in that** the non-linear compensation circuit includes:

   first means (103, 103, 104) deriving an inverse gain as an inverse characteristic of the gain of said amplifier with respect to said input signal, and outputting a reciprocal of said inverse gain;
   a filter (105) receiving and filtering said reciprocal from said first means to output a resulting signal;
   second means (106) receiving the output of the filter and finding a reciprocal of the output of the filter to output said reciprocal; and
   a multiplier (101) multiplying said input signal by an output of said second means.

2. A non-linear compensation circuit for providing an inverse characteristic of an input/output characteristic, termed 'a gain characteristic', of an amplifier, as to an input signal supplied to said amplifier, and for compensating a non-linear characteristic of said amplifier, **characterized in that** the non-linear compensation circuit includes:

   first means (102, 103') deriving a gain of said amplifier with respect to said input signal and outputting the resulting gain;
   a filter (105) receiving and filtering said gain from said first means to output the resulting signal;
   second means (106) receiving the output of the filter and finding a reciprocal of the output of the filter to output said reciprocal; and
   a multiplier (101) multiplying said input signal by an output of said second means.

3. A non-linear compensation circuit comprising:

   a converter (102) receiving a complex baseband signal and converting the received complex baseband signal into an amplitude or power to output the resulting amplitude or power;
   a storage unit (103) storing and holding data representing an inverse characteristic of an input/output characteristic, termed 'inverse gain characteristic', of an amplifier, by a complex number, with respect to an input amplitude or power, and outputting an inverse gain associated with the amplitude or power from said converter;
   a first reciprocal converter (104) receiving said inverse gain output from said storage unit to output a reciprocal of said inverse gain;

a filter (105) receiving an output signal of said first reciprocal converter and filtering said output signal to output a resulting signal;

a second reciprocal converter (106) receiving the output of the filter to output a reciprocal of the output of the filter; and

a complex multiplier receiving the input complex baseband signal and an output signal from said second reciprocal converter to perform complex multiplication to output the result of the complex multiplication.

4. A non-linear compensation circuit comprising:

a converter (102) receiving a complex baseband signal and converting the received complex baseband signal into an amplitude or power to output the amplitude or power;

a storage unit (103') storing and holding data representing a input/output characteristic, termed 'a gain characteristic', of an amplifier, by a complex number, with respect to an input amplitude or power, and outputting a gain associated with the amplitude or power supplied from said converter;

a filter (105) receiving said gain output from said storage unit and filtering said gain to output a resulting signal;

a reciprocal converter (106) receiving the output of said filter to output a reciprocal of said filter output; and

a complex multiplier (101) receiving the input complex baseband signal and an output signal from said reciprocal converter to perform complex multiplication to output the result of the complex multiplication.

5. The non-linear compensation circuit according to any one of claims 1 to 4, wherein said filter has a filter characteristic corresponding to the memory effect of said amplifier.

6. The non-linear compensation circuit according to any one of claims 1 to 5, wherein said filter is an FIR (infinite impulse response) filter.

7. A transmitting apparatus comprising:

a non-linear compensation circuit according to claim 1 or 2; and

said amplifier receiving a signal modulated from an output signal of said non-linear compensation circuit, as an input signal.

8. A transmitting apparatus comprising:

a non-linear compensation circuit (301) according to any one of claims 3 to 6;

a quadrature modulator (302) for quadrature modulating an output signal of said non-linear compensation circuit to output the resulting signal;

an amplifier (303) for amplifying an output signal of said quadrature demodulator to output the resulting signal;

a quadrature demodulator (305) for quadrature demodulating the output signal of said amplifier; and

a memory correction calculation unit (304) receiving an input signal to said non-linear compensation circuit (301) and a signal output from said quadrature demodulator to correct the data of said storage unit in said non-linear compensation circuit (301).

9. A non-linear compensation method for providing an inverse characteristic of an input/output characteristic, termed 'a gain characteristic', of an amplifier, as to an input signal supplied to said amplifier, and for compensating a non-linear characteristic of said amplifier, **characterized in that** said method comprises the steps of:

deriving an inverse characteristic of the gain of said amplifier with respect to said input signal, and for outputting a reciprocal of said inverse characteristic;

filtering said reciprocal to output a resulting signal;

finding a reciprocal of the output of the filtering; and

multiplying said input signal by the reciprocal of the output of the filtering.

10. A non-linear compensation method for providing an inverse characteristic of an input/output characteristic, termed 'a gain characteristic', of an amplifier, as to an input signal supplied to said amplifier, and for compensating a non-linear characteristic of said amplifier, **characterized in that** said method comprises the steps of:

deriving the gain of said amplifier with respect to said input signal;

filtering said gain to output a resulting signal;

finding a reciprocal of the output of the filtering; and

multiplying said input signal by the output of the output of the filtering.

11. A non-linear compensation method **characterized in that** said method comprises the steps of:

receiving a complex baseband signal to convert the received complex baseband signal into an amplitude or power to output said amplitude or power;

outputting, from a memory storing and holding data representing an inverse characteristic of an input/output characteristic, termed 'inverse gain characteristic', of an amplifier, by a complex number, with respect to an input amplitude or power, an inverse gain associated with said output amplitude or power;

finding a reciprocal of said inverse gain output from said memory to output the reciprocal of said inverse gain;

filtering said reciprocal of said inverse gain to output a resulting signal;

finding a reciprocal of the output of the filtering; and

performing complex multiplication of the input complex baseband signal with the reciprocal of the output of the filtering.

**12.** A non-linear compensation method **characterized in that** said method comprises the steps of:

receiving a complex baseband signal for converting the received complex baseband signal into an amplitude or power to output the amplitude or power;

outputting, from a memory storing and holding data representing input/output characteristics, termed 'a gain characteristic', of an amplifier, by a complex number, with respect to an input amplitude or power, a gain associated with said output amplitude or power;

filtering said gain output from said memory to output a resulting signal;

finding a reciprocal of the output of the filtering; and

performing complex multiplication of the input complex baseband signal with the reciprocal of the output of the filtering.

**13.** The non-linear compensation method according to any one of claims 9 to 12, wherein a filter characteristic in said filtering corresponds to the memory effect of said amplifier

**14.** The non-linear compensation method according to claim 13, wherein said filtering is carried out by an FIR (infinite impulse response) filter.

FIG . 1

FIG. 2

INPUT SIGNAL
x(t)

201 OUTPUT
SIGNAL
v(t)

COMPLEX
MULTIPLIER

202

NON-LINEAR
CHARACTER-
ISTICS

a(t)

203

LINEAR
PHASE
FILTER

w(t)

EP 1 496 612 A2

# FIG . 3

```
          START
            │
┌───────────────────────────┐
│ FIND AMPLITUDE OF INPUT SIGNAL │ ～ S1
└───────────────────────────┘
            │
┌───────────────────────────┐
│ ACQUIRE INVERSE GAIN ASSOCIATED │ ～ S2
│        WITH AMPLITUDE      │
└───────────────────────────┘
            │
┌───────────────────────────┐
│ FIND RECIPROCAL OF INVERSE GAIN │ ～ S3
└───────────────────────────┘
            │
┌───────────────────────────┐
│     FIR-FILTER RECIPROCAL OF    │ ～ S4
│          INVERSE GAIN           │
└───────────────────────────┘
            │
┌───────────────────────────┐
│   FIND RECIPROCAL OF FIR FILTER │ ～ S5
│             OUTPUT              │
└───────────────────────────┘
            │
┌───────────────────────────┐
│ COMPLEX MULTIPULICATION OF INPUT│ ～ S6
│ SIGNAL WITH RECIPROCAL FOUND    │
│         IN STEP S5              │
└───────────────────────────┘
            │
           END
```

# FIG . 4

INPUT SIGNAL
r(i)

101
COMPLEX
MULTIPLIER

OUTPUT
SIGNAL

102
AMPLITUDE
CONVERTER

103'
MEMORY
a(i)

105
FIR FILTER
w(i)

106
RECIPROCAL
CONVERTER

1/w(i)

EP 1 496 612 A2

# FIG . 5

START

FIND AMPLITUDE FROM INPUT SIGNAL — S11

ACQUIRE GAIN ASSOCIATED WITH AMPLITUDE — S12

FIR-FILTER GAIN — S13

FIND RECIPROCAL OF FIR FILTER OUTPUT — S14

COMPLEX MULTIPULICATION OF INPUT SIGNAL WITH RECIPROCAL FOUND IN STEP 14 — S15

END

# FIG . 6

INPUT SIGNAL

r(i)

301 PRE-DISTORTER

302 QUADRATURE MODULATOR

306 DAC

308

310

303 AMPLIFIER

OUTPUT SIGNAL

304 MEMORY CORRECTION CALCULATION

305 QUADRATURE DEMODULATOR

307 ADC

309

EP 1 496 612 A2

FIG . 7     PRIOR ART

INPUT SIGNAL

**401** OUTPUT SIGNAL

COMPLEX MULTIPLIER

**402**

AMPLITUDE CONVERTER

**403**

MEMORY